# EUROPEAN PATENT APPLICATION

(11) **EP 4 462 469 A2**
(43) Date of publication of application: **13.11.2024**
(21) Application number: 24172325.3
(22) Date of filing: 25.04.2024
(51) Int. Cl.: H01L 21/56

(54) **ELECTRONIC PACKAGE MOLDING DEVICE, MOLDING METHOD, AND ELECTRONIC PACKAGE MANUFACTURED USING THE SAME**

(30) Priority: 12.05.2023 KR 20230061695
(71) Applicant: Korea Advanced Institute of Science and Technology, Daejeon 34141 (KR)
(72) Inventor: KIM, Seong Su, 305-338 Daejeon (KR); PARK, Seong Yeon, 305-338 Daejeon (KR); ON, Seung Yoon, 305-338 Daejeon (KR)
(74) Representative: Isarpatent

(57) **Abstract**

The present invention relates to an electronic package molding device, a molding method, and an electronic package manufactured using the same, and more specifically, to an electronic package molding device using a planar heating element, a molding method, and an electronic package manufactured using the same.

The electronic package molding device according to one embodiment of the present invention includes a planar heating element configured to mold an electronic package by approaching one surface of an electronic package to melt a molding agent disposed on the one surface of the electronic package and apply pressure to bring the epoxy molding compound into close contact with the electronic package and a gas pressure regulator configured to adjust gas pressure between the electronic package and the planar heating element.

## Description

### CROSS-REFERENCE TO RELATED APPLICATION

This application claims priority to and the benefit of Korean Patent Application No. 10-2023-0061695 filed on May 12, 2023, the disclosure of which is incorporated herein by reference in its entirety.

### BACKGROUND

### 1. Field of the Invention

The present invention relates to an electronic package molding device, a molding method, and an electronic package manufactured using the same, and more specifically, to an electronic package molding device using a planar heating element, a molding method, and an electronic package manufactured using the same.

### 2. Discussion of Related Art

In recent years, with the rapid development of the information and communication field and the popularization of information media such as computers, semiconductor devices are also rapidly being developed.

In terms of functionality, in accordance with the trend toward high integration of semiconductor devices, various methods are being researched to reduce the size of individual semiconductor chips disposed on a substrate, simultaneously maximize performance, and speed up signal processing between chips or other peripheral devices.

In particular, as semiconductor chip miniaturization and circuit design technology reach their limits, electronic package molding technology is rapidly emerging for lightweight and miniaturized semiconductor elements while providing high performance and multi-functionality of the semiconductor elements.

In general, a main material for electronic package molding is an epoxy molding compound (EMC), which is a thermosetting polymer-based composite material, and the electronic package is molded by covering a substrate on which semiconductor chips and wires are disposed with the EMC and applying pressure.

The electronic package molding methods include transfer molding and compression molding.

The transfer molding is a method of performing molding by supplying an EMC melted by applying heat to a substrate on which a semiconductor chip and a wire are disposed at a constant pressure.

The transfer molding has disadvantages that an EMC molding layer may be unevenly formed or voids may easily occur as a structure of the electronic package becomes more complex due to a multi-layer structure of a chip or wire bonding, and an internal mold has to be manufactured according to the shape and thickness of the semiconductor package molding.

The compression molding is a method of performing molding by putting an EMC in a mold, melting the EMC by applying heat, and then lowering a chip and a substrate to an upper side of the EMC.

According to the compression molding, there is no need to flow the EMC, and thus material and energy waste may be reduced compared to the transfer molding, generation of bubbles in the package may be significantly reduced, and the thickness of the electronic package molding may be adjusted by an amount of the EMC, thereby reducing process costs.

However, hot press process equipment mainly used in the compression molding method has a problem of being expensive and requiring considerable cost and time for maintenance and repair.

In addition, since an area of the electronic package is limited by a size of the hot press process equipment and a significant amount of power is required to perform the process, there is a problem that a production rate of semiconductor packages decreases and the price increases.

### SUMMARY OF THE INVENTION

The present invention is intended to solve the aforementioned problems, and is directed to providing an electronic package molding device capable of saving costs, time, materials, and energy as molding is performed by melting an epoxy molding compound (EMC) and applying pressure using a planar heating element, a molding method, and an electronic package module manufactured using the same.

According to an aspect of the present invention, there is provided an electronic package molding device including a planar heating element configured to mold an electronic package by approaching one surface of an electronic package to melt an epoxy molding compound disposed on the one surface of the electronic package and apply pressure to bring the epoxy molding compound into close contact with the electronic package and a gas pressure regulator configured to adjust gas pressure between the electronic package and the planar heating element.

Here, the epoxy molding compound is prepared to contain silica (SiO₂), thermosetting epoxy, anhydrous acid, phenol, amines, coupling, a silane coupling agent, and wax, melts at about 80°C or higher, has a thermal conductivity of about 0.5 W/mk to 2 W/mk, has an elastic modulus of about 30.71 GPa within an error range of about 3.4 GPa at 25°C, has an elastic modulus of about 1.85 GPa within an error range of about 0.26 GPa at 150°C, has a thermal expansion coefficient of about 8.2×10⁻⁶/°C within an error range of about 0.78×10⁻⁶/°C below 145°C, and has a thermal expansion coefficient of about 26.5×10⁻⁶/°C within an error range of 0.63×10⁻⁶/°C above 145°C.

In addition, the electronic package molding device may further include a conductor plate that is attached to a lower surface of the planar heating element and receives heat from the planar heating element, the conductor plate may be disposed on an upper side of the electronic package so that a lower surface of the conductor plate faces an upper surface of the electronic package in parallel, and a molding process of the electronic package may be performed by supplying the epoxy molding compound to the upper surface of the electronic package and applying heat and pressure by bringing the lower surface of the conductor plate into close contact with the epoxy molding compound as the planar heating element descends.

In addition, the gas pressure regulator may include a space bag surrounding the substrate and the planar heating element to form a closed space and a gas inflow and outflow device that controls inflow and outflow of gas inside the space bag.

In addition, the planar heating element may include at least one of CNT, carbon fiber, and carbon black.

In addition, the electronic package molding device may further include a strain measurement sensor configured to measure strain of the epoxy molding compound and a temperature sensor configured to measure temperature of the epoxy molding compound.

In addition, the strain measurement sensor may include one of a strain gauge and a fiber optic sensor, and the temperature sensor includes a thermocouple.

According to another aspect of the present invention, there is provided an electronic package molding method including a gas pressure adjusting operation of adjusting gas pressure between an electronic package and a planar heating element configured to transfer heat to one surface of the electronic package and a molding operation of, by the planar heating element, approaching the one surface of the electronic package to apply heat to an epoxy molding compound disposed on the one surface of the electronic package and at the same time apply pressure to bring the epoxy molding compound into close contact with the electronic package.

Here, the epoxy molding compound is prepared to contain silica (SiO₂), thermosetting epoxy, anhydrous acid, phenol, amines, coupling, a silane coupling agent, and wax, melts at about 80°C or higher, has a thermal conductivity of about 0.5 W/mk to 2 W/mk, has an elastic modulus of about 30.71 GPa within an error range of about 3.4 Gpa at 25°C, has an elastic modulus of about 1.85 Gpa within an error range of about 0.26 Gpa at 150°C, has a thermal expansion coefficient of about 8.2×10⁻⁶/°C within an error range of about 0.78×10⁻⁶/°C below 145°C, and has a thermal expansion coefficient of about 26.5×10⁻⁶/°C within an error range of 0.63×10⁻⁶/°C above 145°C.

In addition, a lower surface of the conductor plate attached to a lower surface of the planar heating element and an upper surface of the electronic package may be vertically disposed to face each other in parallel and the epoxy molding compound is supplied to the upper surface of the electronic package, and the molding operation may be an operation of applying heat and pressure by bringing the lower surface of the conductor plate into close contact with the epoxy molding compound as the planar heating element descends.

In addition, the gas pressure adjusting operation may be an operation of providing a closed space in which a space bag surrounds the substrate and the planar heating element and adjusting a gas pressure inside the space bag by a gas inflow and outflow device.

In addition, the molding operation may be an operation of curing the epoxy molding compound by gradually increasing temperature of the epoxy molding compound to 175°C and then maintaining the temperature at about 175°C for about two hours.

In addition, the planar heating element may include at least one of CNT, carbon fiber, and carbon black.

In addition, in the molding operation, a progress degree of molding may be identified by measuring strain of the epoxy molding compound and temperature of the epoxy molding compound in real time.

In addition, a strain measurement sensor for measuring strain of the epoxy molding compound may include one of a strain gauge and a fiber optic sensor, and a temperature sensor for measuring temperature of the epoxy molding compound may include a thermocouple.

A semiconductor package module according to the present invention is manufactured using the electronic package molding method described above.

### BRIEF DESCRIPTION OF THE DRAWINGS

Embodiments of the present invention will be described with reference to the accompanying drawings described below, in which like reference numerals represent like elements, but are not limited thereto:
FIG. 1 is a cross-sectional view schematically showing a configuration of an electronic package molding device according to one embodiment of the present invention;
FIG. 2 is a perspective view of the electronic package molding device according to one embodiment of the present invention;
FIG. 3 is a view showing a planar heating element attached to an upper mold according to one embodiment of the present invention;
FIG. 4 is a view showing a mold hole connecting the inside and the outside of a lower mold according to one embodiment of the present invention;
FIG. 5 is a time (min)-temperature (°C) graph inside hot press process equipment in the related art when a molding process is performed using the equipment;
FIG. 6 is a time (min)-temperature (°C) graph inside an electronic package molding device according to the present invention when a molding process is performed using the electronic package molding device;
FIGS. 7A and 7B are time (min)-power (W) graphs according to experimental examples when the molding process is performed using the hot press process equipment and when the molding process is performed using the electronic package molding device according to the present invention;
FIG. 8 is a view showing elastic moduli according to experimental examples of an epoxy molding compound molded using the hot press process equipment and an epoxy molding compound molded using the electronic package molding device according to the present invention;
FIG. 9 is a view showing degrees of cure according to experimental examples of the epoxy molding compound molded using the hot press process equipment and the epoxy molding compound molded using the electronic package molding device according to the present invention;
FIGS. 10A and 10B are surface photographs and internal photographs according to experimental examples of the epoxy molding compound molded using the hot press process equipment and the epoxy molding compound molded using the electronic package molding device according to the present invention;
FIG. 11 is a temperature (°C)-curvature (m-1) graph according to experimental examples when the molding process is performed using the hot press process equipment and when the molding process is performed using the electronic package molding device according to the present invention; and
FIG. 12 is a flowchart showing an electronic package molding method using the electronic package molding device according to the present invention.

### DETAILED DESCRIPTION OF EXEMPLARY EMBODIMENTS

Hereinafter, specific details for the practice of the present invention will be described in detail with reference to the accompanying drawings. However, in the following description, detailed descriptions of well-known functions or configurations will be omitted when it may make the subject matter of the present invention rather unclear.

In the accompanying drawings, the same or corresponding components are given the same reference numerals. In addition, in the following description of the embodiments, duplicate descriptions of the same or corresponding components may be omitted. However, even when descriptions of components are omitted, it is not intended that the components are not included in any embodiment.

Advantages and features of embodiments disclosed herein, and methods for achieving the advantages and features will be clarified with reference to embodiments described below together with the accompanying drawings. However, the present invention is not limited to the embodiments disclosed below, but will be implemented in a variety of different forms, and the present embodiment are merely provided to fully inform those skilled in the art to which the present invention pertains of the scope of the present invention.

Unless otherwise defined, all terms (including technical and scientific terms) used herein have the same meanings as commonly understood by those skilled in the art to which the present invention pertains. In addition, terms, such as those defined in commonly used dictionaries, will not be interpreted in an idealized or overly formal sense unless expressly so defined herein.

For example, the term "technique" may refer to a system, method, computer readable instruction, module, algorithm, hardware logic, and/or operation as permitted by the context described above and throughout a document.

Terms used herein will be briefly described, and the disclosed embodiments will be described in detail. The terms used herein are selected from common terms that are currently widely used as much as possible in consideration of functions in the present invention. However, the terms may vary depending on the intentions of those skilled in the art, precedents, appearances of new technologies, or the like. In addition, in certain cases, there are terms arbitrarily selected by the applicant, and in this case, the meanings of the terms will be described in detail in corresponding parts in the following detailed description. Therefore, terms used in the present invention are not simply names of the terms but should be defined based on the meanings of the terms and the entire content of the present invention.

As used herein, an expression used in the singular encompasses the expression of the plural, unless it is clearly specified as singular in context. Also, an expression used in the plural encompasses the expression of the singular, unless it is clearly specified as plural in context. In the entire specification, when a part "includes" or "comprises" a component, unless described to the contrary, the term "includes" or "comprises" does not indicate that the part excludes another component but instead indicates that the part may further include the other component.

In the present invention, terms such as "comprise", "comprising"', and the like may indicate the presence of features, steps, operations, elements and/or components, but the terms do not exclude the addition of one or more other functions, steps, operations, elements, components and/or combinations thereof.

In the present invention, when a specific component is referred to as being "coupled," "combined," "connected," or "related," or "reacting" to any other component, the specific component may be directly coupled, combined, connected, and/or related to, or directly react to the other component, but is not limited thereto. For example, one or more intermediate components may exist between the specific component and the other component. In addition, in the present invention, "and/or" may include each of one or more of the listed items or a combination of at least some of the one or more items.

In the present invention, terms such as "first," "second," and the like are used to distinguish a specific component from another component, and the above-described components are not limited by the terms. For example, a "first" component may be used to refer to an element of the same or similar form as a "second" component.

A system described below constitutes one embodiment and is not intended to limit the scope of the claims to any one specific operating environment. The system can be used in other environments without departing from the technical spirit and scope of the claimed subject matter.

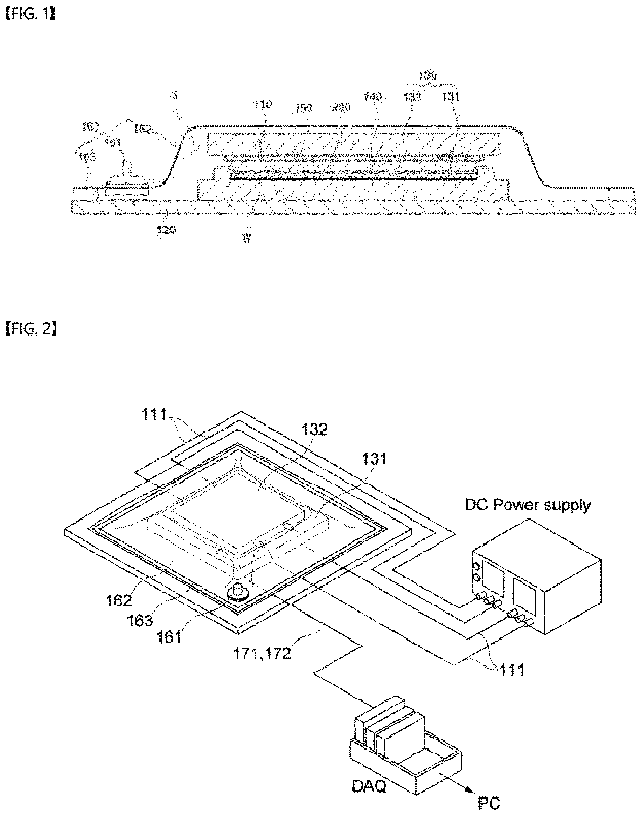

Hereinafter, an electronic package molding device according to one embodiment of the present invention will be described with reference to FIGS. 1 to 4.

FIG. 1 schematically shows a cross-sectional view of a configuration of an electronic package molding device according to one embodiment of the present invention.

Referring to FIG. 1, the electronic package molding device according to the present invention includes a planar heating element 110 for molding an electronic package W by approaching one surface of the electronic package W to melt a molding agent 200 disposed on the one surface of the electronic package W and apply pressure to bring the molding agent into close contact with the electronic package W.

The electronic package W may have a semiconductor chip and a wire disposed on a substrate. The substrate may be a silicon wafer that becomes a semiconductor substrate, and may be a transparent substrate, such as glass or the like, used for flat panel display devices such as a liquid crystal display (LCD) and a plasma display panel (PDP), but is not limited thereto and may be various types of substrates. In addition, the shape and size of the substrate are not limited by the drawings of the present invention, and may have substantially various shapes and sizes, such as circular and square plates.

The molding agent 200 may be provided as an epoxy molding compound (EMC).

The epoxy molding compound may be prepared to contain, for example, silica (SiO₂), thermosetting epoxy, anhydrous acid, phenol, amines, coupling, a silane coupling agent, and wax. Here, the silica used as a filler may be contained in an amount of about 70 wt% to 90 wt%, the thermosetting epoxy used as a base resin may be contained in an amount of about 10 wt% to 15 wt%, the anhydrous acid, phenol, and amines used as a curing agent may be contained in an amount of about 5 wt% to 10 wt%, the coupling used as a catalyst may be contained in an amount of about 0.5 wt%, the silane coupling agent used as a coupling agent may be contained in an amount of about 0.5 wt% to 1 wt%, and the wax used as a mold release agent may be contained in an amount of about 0.5 wt% to 1 wt%. In addition, about 0.5 wt% of carbon black may be additionally contained as a colorant.

In addition, the epoxy molding compound may have a thermal conductivity of about 0.5 W/mk to 2 W/mk and melt at about 80°C or higher.

In addition, the epoxy molding compound may have an elastic modulus of about 30.71 GPa within an error range of about 3.4 GPa at 25°C, and may have an elastic modulus of about 1.85 GPa within an error range of about 0.26 GPa at 150°C.

The epoxy molding compound may have a thermal expansion coefficient of about 8.2×10⁻⁶/°C within an error range of about 0.78×10⁻⁶/°C below 145°C, and have a thermal expansion coefficient of about 26.5×10⁻⁶/°C within an error range of 0.63×10⁻⁶/°C above 145°C.

The planar heating element 110 may be a heating element that converts electrical energy into thermal energy and provides the thermal energy, and may be provided in a thin, flat shape.

The planar heating element 110 may be formed of a carbon-based composition with constant resistance and high thermal efficiency, and may include at least one of CNT, carbon fiber, and carbon black.

In addition, the electronic package molding device 100 may further include a conductor plate 140 that is attached to one surface of the planar heating element 110 and receives heat from the planar heating element.

The conductor plate 140 is used to transfer heat and simultaneously apply pressure in contact with the molding agent 200 to remove voids in the molding and reduce surface roughness, and may be formed of a metal material with high thermal conductivity. For example, the conductor plate 140 may be made of copper, aluminum, or the like.

In addition, the electronic package molding device 100 may include a support on which the electronic package W is supported.

The support may be manufactured in the form of a closed mold 130 to prevent the molding agent 200 from leaking during a molding process of the electronic package W.

The closed mold 130 may be prepared with an insulating material to prevent electrical leakage and heat dissipation. For example, the closed mold 130 may be configured using at least one of materials with excellent insulation and thermal insulation performance, such as glass wool, mineral wool, silica, aerogel, polyurethane, expanded polystyrene (EPS), extruded polystyrene (XPS), and phenol.

The close mold 130 may include a lower mold 131 in which an internal space into which the electronic package W is inserted is formed, and an upper mold 132 provided to cover one open side of the lower mold 131.

Here, the planar heating element 110 and the conductor plate 140 may be attached to the lower mold 131 to move together.

In one embodiment of the present invention, a position of the lower mold 131 may be fixed so that an inner bottom surface remains parallel to a horizontal plane, and the upper mold 132 may be provided to descend from an upper side of the lower mold 131 and cover an open upper side of the lower mold 131.

Here, the planar heating element 110 may be attached to an upper surface of the lower mold 131, and the conductor plate 140 may be attached to a lower surface of the planar heating element 110. In addition, the molding agent 200 may be supplied to an upper surface of the electronic package W, and the upper mold 132 may be provided to descend in a state where a lower surface of the conductor plate 140 faces the upper surface of the electronic package W inserted into the lower mold 131 in parallel.

Accordingly, the molding process of the electronic package W may be performed by applying heat and pressure as the lower surface of the conductor plate 140 is brought into close contact with the molding agent 200.

Here, the pressure applied to the molding agent 200 from the conductor plate 140 may be the sum of the weights of the conductor plate 140, the planar heating element 110, and the upper mold 132.

That is, a constant pressure may be applied to the molding agent 200 without using an external pressure transmission device, thereby saving energy, costs, time, and effort consumed when the external pressure transmission device is used.

In addition, various devices for adjusting pressure may be additionally provided to increase or decrease the pressure applied to the molding agent 200.

In addition, the electronic package molding device 100 includes a gas pressure regulator 160 for adjusting gas pressure between the electronic package W and the planar heating element 110.

The gas pressure regulator 160 may include a space bag 162 surrounding the substrate W and the planar heating element 110 to form a closed space S and a gas inflow and outflow device 161 controlling inflow and outflow of gas inside the space bag 162.

The gas inflow and outflow device 161 may be a vacuum generator, and may form a vacuum in the closed space S by sucking in the gas inside the space bag 162. Here, the vacuum may refer to a pressure state below atmospheric pressure (1 atm), or may refer to a high vacuum state where the pressure is close to 0.

A user may adjust the gas pressure state inside the space bag 162 by adjusting the gas inflow and outflow device 161, and may lower the gas pressure inside the space bag 162, thereby preventing voids from occurring inside the molding agent 200.

In addition, a molding process table 120 on which the lower mold 131 is supported may be provided, and the closed space S may be formed by connecting an edge of the space bag 162 to the molding process table 120 and sealing a space between the space bag 162 and the molding process table 120 using a sealing agent 163. Here, the molding process table 120 may have a structure in which the lower mold 131 is extended. In addition, the closed space S is not limited thereto and may be formed in various ways.

In addition, a coating film may be inserted between the molding agent 200 and the conductor plate 140.

The coating film is for surface gloss of package molding and stable demolding after the molding process, and may be made using polyimide (PI), polytetrafluoroethylene (PTFE), polyethylene naphthalate (PEN), polyester (PET), or the like which may have excellent chemical resistance and maintain stable performance.

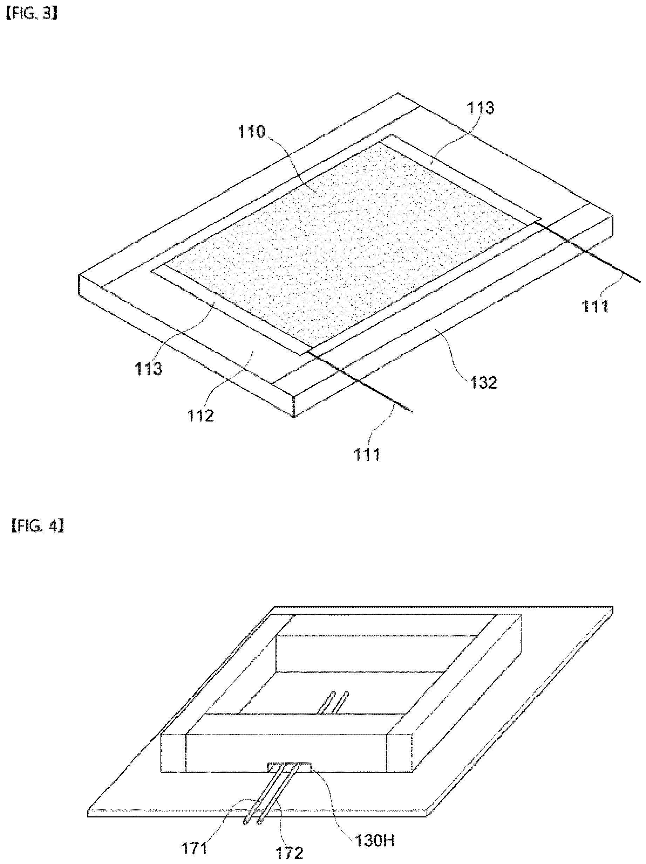

FIG. 2 schematically shows a perspective view of the electronic package molding device according to one embodiment of the present invention. Hereinafter, FIGS. 3 and 4 will be described with reference to FIG. 2.

FIG. 3 is a view in which the planar heating element 110 is attached to the upper mold 132 according to one embodiment of the present invention.

According to one embodiment of the present invention, a conductive wire 111 for transmitting electrical energy from an external power supply (a DC power supply, see FIG. 2) may be connected to the planar heating element 110.

In addition, the planar heating element 110 may be fixed to the upper mold 132 using a tape 112, and the conductive wire 111 may be fixed to the planar heating element 110 using a tape 113.

Here, the tapes 112 and 113 having insulating properties may be provided to prevent short circuit to the conductor plate 140, and may be provided as tapes made using polytetrafluorothylene (PTFE), rubber, epoxy, glass fiber, polyester (PET), or polyimide (PI), or the like, or as metal tapes, but are not limited thereto, and may be provided as tapes made using various materials.

FIG. 4 is a view in which a mold hole 130H for connecting the inside and the outside of the lower mold 131 is provided according to one embodiment of the present invention.

According to one embodiment of the present invention, a strain measurement sensor (not shown) and a temperature sensor (not shown) may be provided inside the closed mold 130 to measure strain of the molding agent 200 and temperature of the molding agent 200, respectively, while the molding process is performed.

According to one embodiment of the present invention, the strain measurement sensor may be any one of a strain gauge or a fiber optic sensor, and the temperature sensor may be a thermocouple. In addition, the strain measurement sensor and the temperature sensor are not limited to the embodiments of the present invention and may be provided in various types.

The strain measurement sensor and the temperature sensor may be inserted into the close mold 130 through the mold hole 130H. For example, the strain measurement sensor and the temperature sensor may be attached to the substrate of the electronic package W or inserted into the middle of the molding agent 200 covering the upper surface of the electronic package W, but are not limited thereto and may be inserted into various locations to measure the strain and temperature of the molding agent 200.

In addition, the mold hole 130H may be used as a passage through which conductive wires 171 and 172 connecting the strain measurement sensor and the temperature sensor to the external power supply (not shown) and a data collector DAQ (see FIG. 4) pass.

The data collector DAQ may be composed of hardware including a sensor, a signal processing device, and a storage device and software for performing data sampling, analysis, and control, and may include the strain measurement sensor and the temperature sensor.

The strain measurement sensor and the temperature sensor may measure the strain and temperature of the molding agent 200 in real time, and the data collector DAQ may identify a progress degree of molding by analyzing the measured strain of the molding agent 200 and the measured temperature of the molding agent 200.

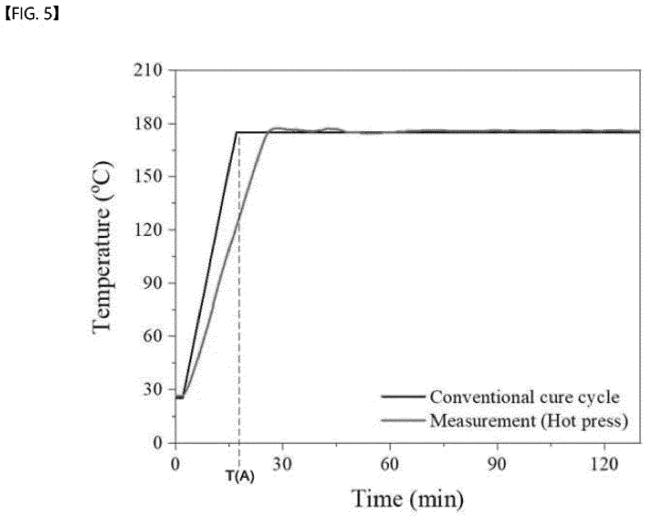

FIG. 5 is a time (min)-temperature (°C) graph inside hot press process equipment in the related art when a molding process is performed using the equipment, showing each of a conventional cure cycle (Conventional cure cycle) and an experimental example (Measurement (Hot press)) using the hot press process equipment.

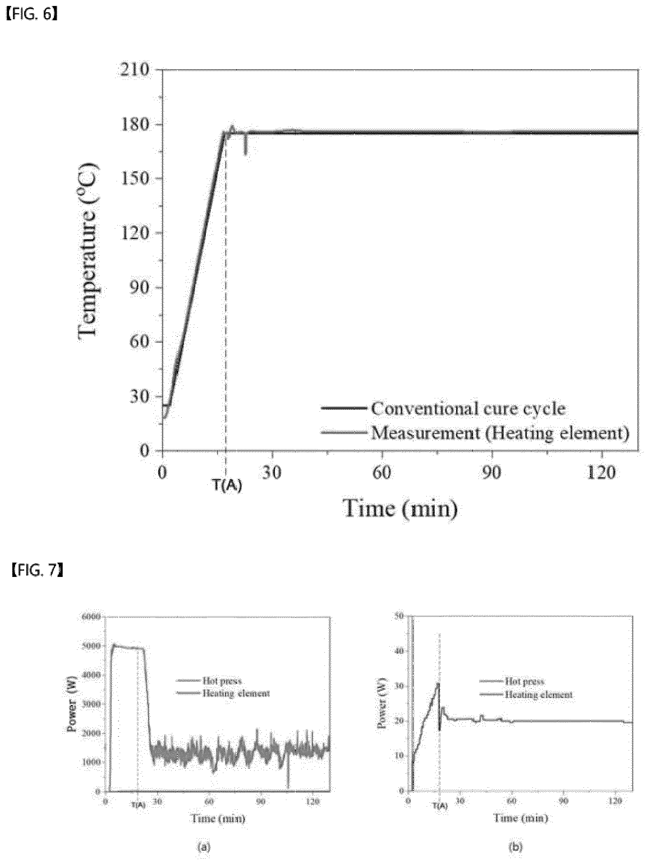

FIG. 6 is a time (min)-temperature (°C) graph inside an electronic package molding device according to the present invention when a molding process is performed using the electronic package molding device, showing each of the conventional cure cycle (Conventional cure cycle) and an experimental example (Measurement (Heating element)) using the electronic package molding device according to the present invention.

In FIGS. 5 and 6, the temperature inside the equipment may be the temperature of the epoxy molding compound used as the molding agent 200.

In the molding process using the epoxy molding compound, the temperature of the epoxy molding compound rises to about 175°C, is maintained at that temperature for about 2 hours, and then is cured. In the drawings of the present specification, an elapsed time until the temperature of the epoxy molding compound rises to 175°C in the conventional cure cycle is expressed as T(A).

Referring to FIGS. 5 and 6, it can be seen that a temperature increase rate is about 7.5°C/min, which is slower than that of the conventional cure cycle, in the experimental example (Measurement (Hot press)) in FIG. 5, and that the temperature increase rate is about 10°C/min, which is almost identical to the conventional cure cycle, in the experimental example (Measurement (Heating element)) in FIG. 6.

That is, it can be seen that the internal temperature increase rate by the electronic package molding device of the present invention is faster than the internal temperature increase rate using the hot press process equipment and almost no energy loss occurs.

In addition, FIGS. 7A and 7B are time (min)-power (W) graphs according to experimental examples when the molding process is performed using the hot press process equipment (Hot press) and when the molding process is performed using the electronic package molding device according to the present invention (Heating element).

FIGS. 7A and 7B show different axis ranges of power W in the graphs, and referring to FIGS. 7A and 7B, it can be seen that power consumption is reduced to less than 1/100 when the molding process is performed using the electronic package molding device according to the present invention compared to when the molding process is performed using the hot press process equipment (Hot press).

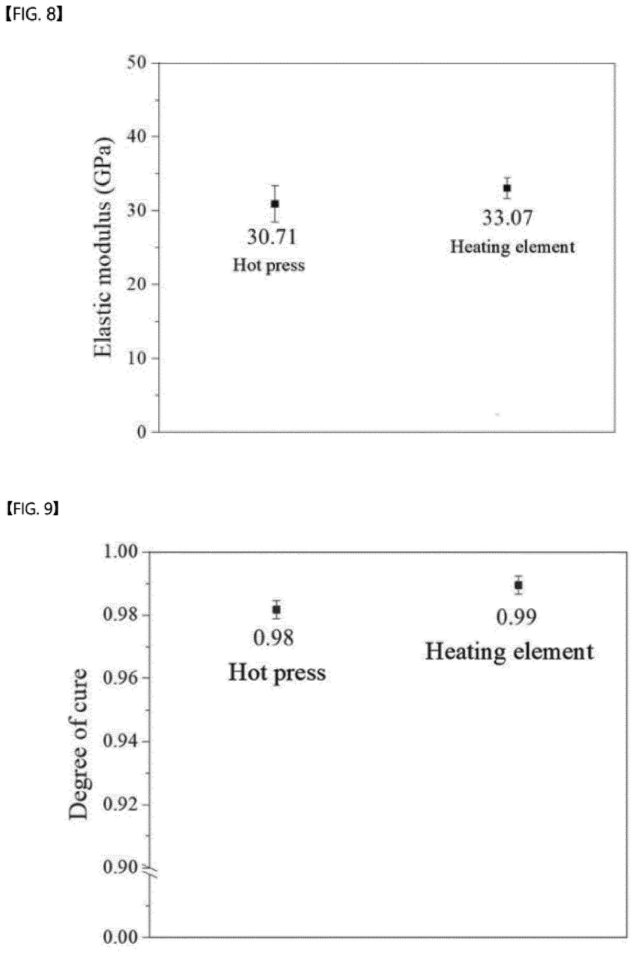

In addition, FIG. 8 shows elastic moduli (Gpa) according to experimental examples of an epoxy molding compound molded using the hot press process equipment (Hot press) and an epoxy molding compound molded using the electronic package molding device according to the present invention (Heating element).

In addition, FIG. 9 shows degrees of cure according to experimental examples of the epoxy molding compound molded using the hot press process equipment (Hot press) and the epoxy molding compound molded using the electronic package molding device according to the present invention (Heating element).

In addition, referring to FIGS. 8 and 9, the elastic moduli and degrees of cure of the epoxy molding compound molded using the hot press process equipment (Hot press) and the epoxy molding compound molded using the electronic package molding device according to the present invention (Heating element) appear similar, and thus it can be confirmed that there is no difference in function.

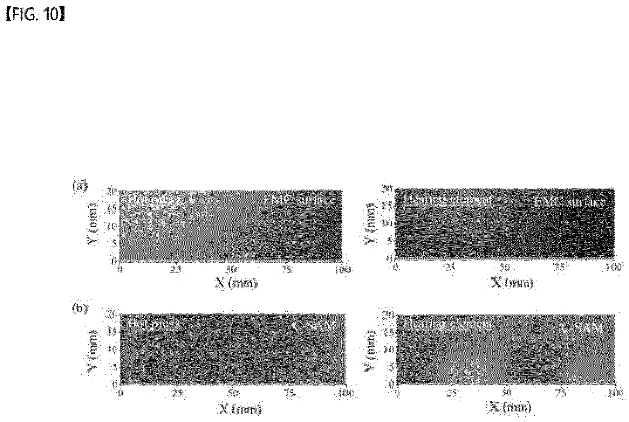

In addition, FIGS. 10A and 10B are surface photographs (FIG. 10A) and internal photographs (FIG. 10B) according to the experimental examples of the epoxy molding compound molded using the hot press process equipment (Hot press) and the epoxy molding compound molded using the electronic package molding device according to the present invention (Heating element).

In the experimental examples of FIGS. 10A and 10B, the same coating film 150 was used during molding using the hot press process equipment and the electronic package molding device according to the present invention, and similar gloss can be confirmed through the surface photographs (FIG. 10A).

In addition, when the internal photographs (FIG. 10B) are compared, since the internal void and interface peeling are similarly confirmed, it can be confirmed that there is no difference in function.

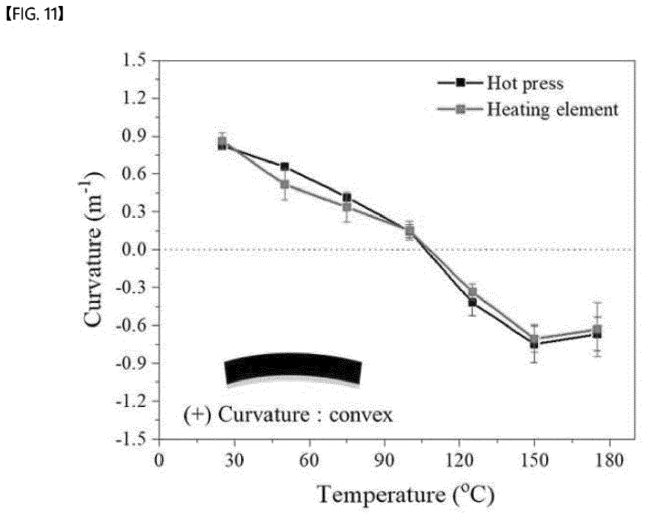

In addition, FIG. 11 is a temperature (°C)-curvature (m-1) graph according to experimental examples when the molding process is performed using the hot press process equipment (Hot press) and when the molding process is performed using the electronic package molding device according to the present invention (Heating element).

Referring to FIG. 11, curvature graphs when the molding process is performed using the hot press process equipment (Hot press) and when the molding process is performed using the electronic package molding device according to the present invention (Heating element) appear similar, and thus it can be confirmed that there is no difference in function.

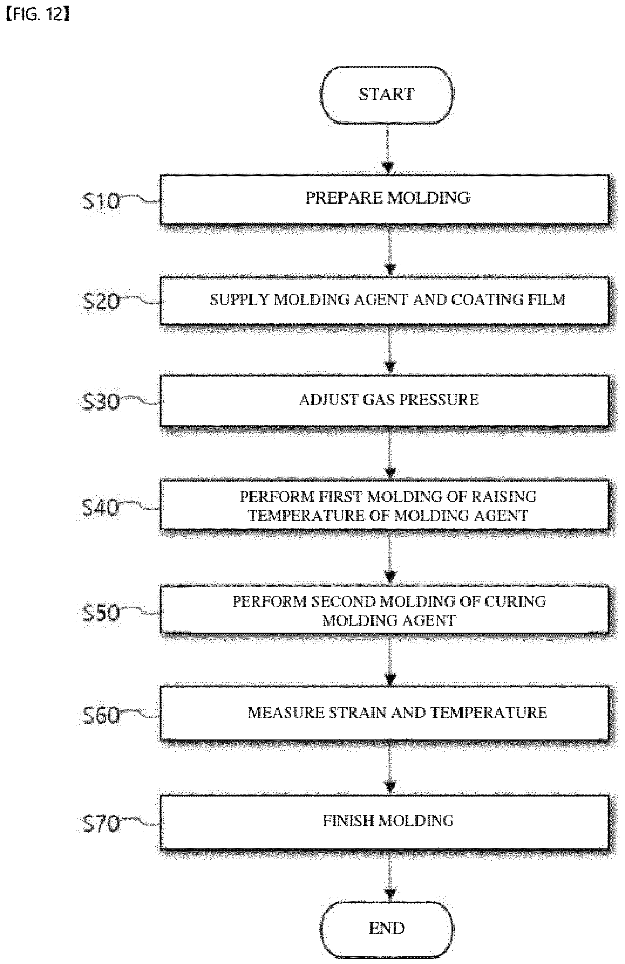

Hereinafter, referring to FIG. 12, an electronic package molding method using an electronic package molding device according to the present invention will be described.

Operation S10 is a molding preparation operation of supporting an electronic package W on a lower mold 131.

Operation S20 is an operation of supplying a molding agent 200 to the upper surface of the electronic package W and putting a coating film 150 on the upper side of the molding agent 200.

Operation S30 is a gas pressure adjusting operation of adjusting gas pressure between the electronic package W and a planar heating element 110.

For example, a gas inflow and outflow device 161 sucks in gas inside a space bag 162 surrounding the electronic package W and the planar heating element 110 so that a vacuum environment below atmospheric pressure may be formed inside the space bag 162.

Operation S40 is a first molding operation of supplying electrical energy to the planar heating element 110 and converting the electrical energy into thermal energy, and applying heat and pressure by bringing the lower surface of a conductor plate 140 into close contact with the molding agent 200 as the planar heating element 110 descends.

In this case, the lower surface of the conductor plate 140 and the upper surface of the electronic package W may be maintained facing each other in parallel vertically.

In operation S40, the temperature of the molding agent 200 gradually increases, and the epoxy molding compound used as one example in the description of the present invention melts at about 80°C and evenly covers the top of the electronic package W.

Operation S50 is a second molding operation of curing the molding agent 200 while maintaining the curing temperature for a preset curing time when the temperature of the molding agent 200 reaches a preset curing temperature.

For the epoxy molding compound used as one example in the description of the present invention, the curing temperature is 175°C.

Operation S60 is an operation of measuring the strain of the molding agent 200 and the temperature of the molding agent 200 through a strain measurement sensor (not shown) and a temperature sensor (not shown), and may be performed in real time while operations S30 and S40 are performed, through which the progress degree of molding may be identified.

Operation S70 is an operation of separating the electronic package W for which the molding process has been finished from a closed mold 130.

As described above, according to the electronic package molding device, the method, and the electronic package manufactured using the same, costs, time, materials, and energy may be saved by performing molding by melting the molding agent and applying pressure using the planar heating element.

According to an electronic package molding device, a molding method, and an electronic package manufactured using the same, costs, time, materials, and energy can be saved by performing molding by melting an EMC and applying pressure using a planar heating element.

The effects of the present invention are not limited to the effects mentioned above, and other effects not mentioned can be clearly understood by those skilled in the art to which the present invention pertains (referred to as "those skilled in the art") from the description of the claims.

The above description of the present invention is for illustration, and those skilled in the art to which the present invention pertains could understand that it may be easily modified into other specific forms without changing the technical spirit or essential features of the present application. Therefore, it should be appreciated that the embodiments described above are intended to be illustrative in all respects and not restrictive. For example, each component described as a single type may be implemented in a distributed manner, and similarly, components described to be distributed may also be implemented in a combined form.

Accordingly, the spirit of the present invention should not be limited to the above-described embodiments, and not only the claims described below, but also all modifications equivalent to the claims should fall within the scope of the spirit of the present invention.

## Claims

1. An electronic package molding device comprising:
a planar heating element configured to mold an electronic package by approaching one surface of an electronic package to melt an epoxy molding compound disposed on the one surface of the electronic package and apply pressure to bring the epoxy molding compound into close contact with the electronic package; and
a gas pressure regulator configured to adjust gas pressure between the electronic package and the planar heating element,
wherein the epoxy molding compound is prepared to contain silica (SiO₂), thermosetting epoxy, anhydrous acid, phenol, amines, coupling, a silane coupling agent, and wax, melts at about 80°C or higher, has a thermal conductivity of about 0.5 W/mk to 2 W/mk, has an elastic modulus of about 30.71 GPa within an error range of about 3.4 GPa at 25°C, has an elastic modulus of about 1.85 GPa within an error range of about 0.26 GPa at 150°C, has a thermal expansion coefficient of about 8.2×10⁻⁶/°C within an error range of about 0.78×10⁻⁶/°C below 145°C, and has a thermal expansion coefficient of about 26.5×10⁻⁶/°C within an error range of 0.63×10⁻⁶/°C above 145°C.

2. The electronic package molding device of claim 1, further comprising a conductor plate that is attached to a lower surface of the planar heating element and receives heat from the planar heating element,
wherein the conductor plate is disposed on an upper side of the electronic package so that a lower surface of the conductor plate faces an upper surface of the electronic package in parallel, and
a molding process of the electronic package is performed by supplying the epoxy molding compound to the upper surface of the electronic package and applying heat and pressure by bringing the lower surface of the conductor plate into close contact with the epoxy molding compound as the planar heating element descends.

3. The electronic package molding device of claim 1, wherein the gas pressure regulator includes:
a space bag surrounding the substrate and the planar heating element to form a closed space; and
a gas inflow and outflow device that controls inflow and outflow of gas inside the space bag.

4. The electronic package molding device of claim 1, wherein the planar heating element includes at least one of CNT, carbon fiber, and carbon black.

5. The electronic package molding device of claim 1, further comprising:
a strain measurement sensor configured to measure strain of the epoxy molding compound; and
a temperature sensor configured to measure temperature of the epoxy molding compound.

6. The electronic package molding device of claim 5, wherein the strain measurement sensor includes one of a strain gauge and a fiber optic sensor, and the temperature sensor includes a thermocouple.

7. An electronic package molding method comprising:
a gas pressure adjusting operation of adjusting gas pressure between an electronic package and a planar heating element configured to transfer heat to one surface of the electronic package; and
a molding operation of, by the planar heating element, approaching the one surface of the electronic package to apply heat to an epoxy molding compound disposed on the one surface of the electronic package and at the same time apply pressure to bring the epoxy molding compound into close contact with the electronic package,
wherein the epoxy molding compound is prepared to contain silica (SiO₂), thermosetting epoxy, anhydrous acid, phenol, amines, coupling, a silane coupling agent, and wax, melts at about 80°C or higher, has a thermal conductivity of about 0.5 W/mk to 2 W/mk, has an elastic modulus of about 30.71 GPa within an error range of about 3.4 GPa at 25°C, has an elastic modulus of about 1.85 GPa within an error range of about 0.26 GPa at 150°C, has a thermal expansion coefficient of about 8.2×10⁻⁶/°C within an error range of about 0.78×10⁻⁶/°C below 145°C, and has a thermal expansion coefficient of about 26.5×10⁻⁶/°C within an error range of 0.63×10⁻⁶/°C above 145°C.

8. The electronic package molding method of claim 7, wherein a lower surface of the conductor plate attached to a lower surface of the planar heating element and an upper surface of the electronic package are vertically disposed to face each other in parallel and the epoxy molding compound is supplied to the upper surface of the electronic package, and
the molding operation is an operation of applying heat and pressure by bringing the lower surface of the conductor plate into close contact with the epoxy molding compound as the planar heating element descends.

9. The electronic package molding method of claim 7, wherein the gas pressure adjusting operation is an operation of providing a closed space in which a space bag surrounds the substrate and the planar heating element and adjusting a gas pressure inside the space bag by a gas inflow and outflow device.

10. The electronic package molding method of claim 7, wherein the molding operation is an operation of curing the epoxy molding compound by gradually increasing temperature of the epoxy molding compound to 175°C and then maintaining the temperature at about 175°C for about two hours.

11. The electronic package molding method of claim 7, wherein the planar heating element includes at least one of CNT, carbon fiber, and carbon black.

12. The electronic package molding method of claim 7, wherein in the molding operation, a progress degree of molding is identified by measuring strain of the epoxy molding compound and temperature of the epoxy molding compound in real time.

13. The electronic package molding method of claim 12, wherein a strain measurement sensor for measuring strain of the epoxy molding compound includes one of a strain gauge and a fiber optic sensor, and a temperature sensor for measuring temperature of the epoxy molding compound includes a thermocouple.

14. A semiconductor package module manufactured by the electronic package molding method of any one of claims 7 to 13.
